**Europäisches Patentamt**

**European Patent Office**

**Office européen des brevets**

(19)

(11) Veröffentlichungsnummer : **0 112 410 B2**

(12)

# NEUE EUROPÄISCHE PATENTSCHRIFT

(45) Veröffentlichungstag der neuen Patentschrift :
06.05.92 Patentblatt 92/19

(51) Int. Cl.$^5$ : **H03C 1/60**

(21) Anmeldenummer : **82201663.0**

(22) Anmeldetag : **28.12.82**

(54) **Einseitenbandsender.**

(43) Veröffentlichungstag der Anmeldung :
04.07.84 Patentblatt 84/27

(45) Bekanntmachung des Hinweises auf die
Patenterteilung :
30.09.87 Patentblatt 87/40

(45) Bekanntmachung des Hinweises auf die
Entscheidung über den Einspruch :
06.05.92 Patentblatt 92/19

(84) Benannte Vertragsstaaten :
CH DE FR GB LI

(56) Entgegenhaltungen :
DE-A- 2 129 884
FR-A- 908 223
US-A- 2 900 459
US-A- 2 944 228
US-A- 4 176 319
L.R.KAHN: "Single-Sideband Transmission by
Envelope Elimanation and Restoration",Proc.of the I.R.E,Juli 1952, S.803-806
L.R.KAHN: "Comparison of Linear Single Sideband Transmitters with Envelope Elimanation and Restoration Single
SidebandTransmitters",Proc.of the I.R.E, Dezember 1956, S. 1706-1712,

(56) Entgegenhaltungen :
H.Meinke/F.W.Gundlach: "Taschenbuch der
Hochfrequenztechnik", 3.Aulage, Springer
Verlag,Berlin,1968,Kapitel U:
"Modulation"und W: "Sender"
M.Lohdal,R.Müller,J.Zeis: "Energiesparende
Rundfunk-Einseitenbandsender",BMFT-Abschlussbericht,April 1982, S.
32-34
V.Petrovic,W.Gosling: "Polar-Loop Transmitter",Electronics Letters, 10.Mai 1979,Bd.15,
Nr.10,S.286-288
M.Sempert: "Neue Wege in der Entwicklung
von Hochleistungs-Rundfunksendern",Bull.
SEV/VSE 73 (1982),17,4. September,S.903-907
W.Tschol, J.Kane: "New Directions in High
Power Broadcast Transmitter Design", Ibc 82
International Broadcasting Convention,Brighton,United Kingdom,18.-21. Semptember 1982,
S.107-111
F.Langmeier, A. Furrer: "Der neue 250-KW-
Kurzwellensender"Brown Boveri Mitt. (1982)
6, S.212-217.

(73) Patentinhaber : **BBC Brown Boveri AG**
**Haselstrasse**
**CH-5401 Baden (CH)**

(72) Erfinder : **Kyrian, Bohumil, Dipl.-Ing.**
**Ursprung 293**
**CH-5224 Unterbözberg (CH)**

Jouve, 18, rue Saint-Denis, 75001 PARIS

## Beschreibung

Die vorliegende Erfindung betrifft einen Einseitenbandsender gemäss dem Oberbegriff des Anspruchs 1. Ein solcher Sender ist z.B. aus der DE-A 21 29 884 bekannt.

Bei einem üblichen Mittelwellen- oder Kurzwellensender mit Amplitudenmodulation (AM) enthält das abgestrahlte Frequenzspektrum der mit einem Niederfrequenz (NF)-Signal amplitudenmodulierten Trägerfrequenz ausser dieser Trägerfrequenz zwei Seitenbänder, von denen das eine nur wenig oberhalb und das andere nur wenig unterhalb der Trägerfrequenz liegen. Jedes dieser Seitenbänder hat die Breite des ursprünglichen NF-Bandes und beinhaltet für sich genommen bereits die vollständige Information des NF-Signals. Da sich die gesamte Sendeleistung auf beide Seitenbänder und die Trägerfrequenz aufteilt, ist der Leistungseinsatz für die Informationsübertragung unverhältnismässig hoch und der Wirkungsgrad, bezogen auf die übertragene Information, vergleichsweise gering. Darüber hinaus ist mit der Übertragung beider Seitenbänder auch die benötigte Kanalbreite wenigstens doppelt so gross, wie beim Einseitenband (ESB)-Betrieb, obgleich mit dem zusätzlichen Band keine zusätzliche Information übertragen wird.

Um bei reduzierter Kanalbreite die im Sender benötigte Leistung besser auszunutzen, verwendet man, insbesondere bei kleinen Mobilfunkstationen, seit langem ESB-Sender. Besondere Bedeutung kommt jedoch der Energieeinsparung durch den ESB-Betrieb bei Rundfunksendern grosser Leistung zu, bei denen der Energieeinsatz ein wesentlicher Faktor in der Betriebskostenrechnung ist. Man hat daher frühzeitig versucht, Rundfunksender mit ESB-Modulation zu betreiben. Bereits existierende AM-Sender werden dabei häufig für die Anwendung des ESB-Verfahrens in der folgenden Weise modifiziert: Der AM-Modulator, meist ein Gegentakt-B-Verstärker mit einem ausgangsseitigen Modulationstransformator, wird stillgelegt. Die ESB-Modulation wird auf kleinem Leistungsniveau an der Hochfrequenz (HF)-Quelle des Senders, also z.B. am Trägerfrequenzoszillator oder Synthesizer, durchgeführt. Der Sender arbeitet dann als linearer Leistungsverstärker für das ESB-Signal, wobei die Verstärkerstufen von dem bei AM-Modulation üblichen C-Betrieb auf B-Betrieb umgestellt werden.

Diese Art der Modifizierung reduziert zwar die Kanalbreite des Senders beträchtlich. Die erreichbare Spitzenleistung (PEP) beträgt jedoch nur etwa 50% der Sender-Nennleistung. Wird darüber hinaus auch noch ein Restträger ausgestrahlt, liegt die ESB-Leistung möglicherweise sogar unter der im AM-Betrieb erreichbaren. Im übrigen verschlechtert sich der gesamte Senderwirkungsgrad durch den Uebergang auf B-Betrieb im Leistungsteil erheblich, so dass der Nutzen einer solchen Umstellung zumindest gering, wenn nicht sogar zweifelhaft ist.

Eine andere Möglichkeit des ESB-Betriebs besteht darin, das Einseitenband in der Senderendstufe auf hohem Leistungsniveau durch eine geeignete Kombination von AM- und Frequenz (FM)-Modulation zu erzeugen. Ein solches Verfahren wird beispielsweise in dem Artikel von 0. Villard, Electronics, Vol. 21, Nov. 1948, S. 86 ff. beschrieben. Das dort dargestellte ESB-System besteht aus einer kombinierten Amplituden- und Phasenmodulation, bei der eine konstante Phasenverschiebung von 90° zwischen den beiden sonst identischen NF-Modulationssignalen eingehalten wird. Durch diese Phasenverschiebung ergibt sich eine weitgehende Unterdrückung der beiden oberen oder unteren Seitenbänder im resultierenden Frequenzspektrum. In der Praxis erweist es sich jedoch als aussergewöhnlich schwierig, geeignete Phasenschieber aufzubauen, welche die geforderte 90°-Verschiebung über den breiten Frequenzbereich eines Rundfunksenders gewährleisten.

Eine weitere Art von ESB-Sendern ist aus dem Artikel von L. Kahn, Proc. I. R. E., July 1952, S. 803 ff., bekannt. Auch dort wird von einer kombinierten Amplituden- und Phasenmodulation ausgegangen, die in der Senderendstufe zu einem verstärkten ESB-Signal führt. Anders als bei dem vorgenannten ESB-Verfahren werden hier jedoch nicht zwei gleichartige, um 90° phasenverschobene NF-Modulationssignale benutzt, sondern das in einem ESB-Generator erzeugte ESB-Signal, das aus einer amplitudenmodulierten und einer phasenmodulierten Komponente besteht, wird bei kleiner Leistung in diese Komponenten zerlegt. Die phasenmodulierte Komponente wird für sich verstärkt und als phasenmodulierter Träger benutzt. Die amplitudenmodulierte Komponente wird ebenfalls für sich in einem üblichen Gegentakt-B-Modulator verstärkt und in bekannter Weise auf den phasenmodulierten Träger als Hüllkurve aufmoduliert. Durch die Kombination beider Komponenten ergibt sich wieder das ursprüngliche ESB-Signal in verstärkter Form.

Probleme treten bei dem beschriebenen ESB-Sender für den allgemeinen Fall auf, dass es sich bei dem NF-Signal um ein Audiosignal mit einem zeitlich veränderlichen Amplitudenmittelwert handelt. In diesem Fall enthält die amplitudenmodulierte Komponente des ESB-Signals einen zeitlich veränderlichen Gleichspannungsanteil, der über den Modulationstransformator des Amplitudenmodulators nicht übertragen werden kann. Aus diesem Grunde muss eine zusätzliche Schaltung zur Trägersteuerung vorgesehen werden, die z.B. eine Reihe von Gleichspannungsverstärkern enthält und über ein Röhrengitter die Endstufe des Senders in Abhängigkeit von dem erwähnten Gleichspannungsanteil steuert. Die Trägeramplitude kann auf diese Weise nur von ihrem Nominalwert bis auf Null gesteuert werden. Die obere Halbwelle hingegen lässt sich hierdurch nicht reali-

sieren. Wegen des erheblichen, zusätzlichen Aufwandes, den die vollwertige Trägersteuerung mit sich bringen würde, wird diese Senderart im wesentlichen für die Telegraphie mit Frequenzumtastung verwendet, weil dort wegen der konstanten Signalamplituden eine Trägersteuerung nicht notwendig ist und die Anforderungen an die Linearität des Senders vergleichsweise gering sind.

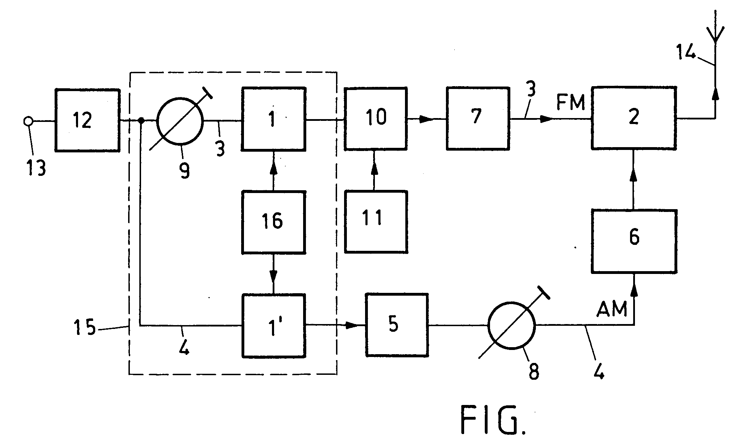

Aus der FR-A 908 223 ist es nun bekannt, bei einem ESB-Sender im Amplitudenmodulationspfad einen Verstärker (A2 in Fig. 1) vorzusehen, der auch eine Gleichspannungskomponente zu übertragen vermag. Mit dieser Massnahme kann auf zusätzliche Mittel zur Trägersteuerung verzichtet werden

Weiterhin ist es aus anderen Druckschriften (US-A 2 944 228 oder US-A 2 900 459) bekannt, bei ESB-Sendern ohne gleichspannungsgekoppelten Amplitudenmodulationspfad in diesem Pfad einen Hüllkurvendetektor vorzusehen.

Darüberhinaus ist es aus den BBC Mitteilungen, 1982, S. 212 ff bekannt, in einem herkömmlichen Rundfunksender als Modulationsverstärker einen sogenannten Schaltverstärker einzusetzen, weil dieser dem Sender einen besonders guten Wirkungsgrad bringt.

Alle zuletzt genannten Merkmale sind schliesslich in einem ESB-Sender verwirklicht, wie er in der eingangs genannten DE-A 2 129 884 offenbart ist (Fig. 1). Bei diesem Sender wird der Amplitudenmodulationspfad aus einem Hüllkurvendetektor, einem PDM-Modulator, einem PDM-Verstärker und einem nachgeschalteten Tiefpassfilter gebildet. Der Frequenzmodulationspfad umfasst einen Begrenzer, einen Vorverstärker und einen modulierten Verstärker.

Obgleich dieser Sender einfach aufgebaut werden kann und einen hohen Wirkungsgrad aufweist, sind bei ihm keine Massnahmen zum Ausgleich der unterschiedlichen Uebertragungseigenschaften von Amplituden- und Frequenzmodulationspfad vorgesehen, sodass die Uebertragungsqualität zu wünschen übrig lässt.

Der vorliegenden Erfindung liegt daher die Aufgabe zugrunde, einen ESB-Sender zu schaffen, der einerseits mit dem Prinzip der kombinierten Amplituden- und Phasenmodulation einen besonders guten Wirkungsgrad und insbesondere eine hohe Spitzenleistung (PEP) aufweist, und der andererseits ohne grossen, zusätzlichen schaltungstechnischen Aufwand durch eine deutlich verbesserte Uebertragungsqualität zur Rundfunkübertragung geeignet ist.

Die Aufgabe wird dadurch gelöst, dass bei einem ESB-Sender der eingangs genannten Art die Merkmale aus dem Kennzeichen des Anspruchs 1 vorgesehen sind.

Die an sich bekannte Gleichspannungskopplung beim Amplitudenmodulations(AM)-Pfad gewährleistet, dass die gesamte amplitudenmodulierte Komponente einschliesslich ihres Gleichspannungsanteils über den AM-Pfad auf die Senderendstufe übertragen werden kann, so dass für die Trägersteuerung kein zusätzlicher Modulationspfad benötigt wird. Der Amplitudenmodulator ist dabei ein Schaltverstärker.

Erfindungsgemäss ist zunächst im AM-Pfad zwischen dem Hüllkurvendetektor und dem Amplitudenmodulator eine Phasenkorrekturschaltung angeordnet. Diese Phasenkorrekturschaltung gleicht Phasenverschiebungen zwischen den Grund- und Oberwellen im AM-Pfad aus, die im notwendigen Tiefpassfilter am Ausgang des Schaltverstärkers hervorgerufen werden. Durch den Einsatz eines Schaltverstärkers wird bei gleichzeitiger Gleichspannungskopplung der Wirkungsgrad des Senders gegenüber anderen bekannten Sender-Schaltungen wesentlich verbessert.

Erfindungsgemäss ist weiterhin der ESB-Generator aus zwei gleichartigen ESB-Modulatoren aufgebaut, von denen jeweils ein ESB-Modulator einem Modulationspfad zugeordnet ist, sowie vor dem ESB-Modulator des FM-Pfades in diesem Pfad eine Signalkorrekturschaltung angeordnet, welche die Uebertragungscharakteristik des Amplitudenmodulators nachbildet. Dadurch wird eine Angleichung der Frequenz- und Phasengänge in den beiden Pfaden erreicht, so dass sich bei der anschliessenden Kombination der amplituden- und phasenmodulierten Komponente in der Senderendstufe mit hoher Genauigkeit wieder das ursprüngliche ESB-Signal ergibt. Dies führt gegenüber den bekannten Schaltungen zu einer wesentlich verbesserten Uebertragungsqualität.

Besonders vorteilhaft für die Qualität der Rundfunkübertragung ist es, wenn der AM-Pfad gemäss einer Ausgestaltung der Erfindung eine Bandbreite von 0 Hz bis wenigstens 5 kHz und innerhalb dieser Bandbreite einen linearen Frequenzgang aufweist. Dann werden auch die in der amplitudenmodulierten Komponente enthaltenen Oberwellen in einer Weise übertragen, dass sich in der Endstufe des Senders wiederum das weitgehend unverzerrte ESB-Signal ergibt.

Günstig ist es weiterhin, als Amplitudenmodulator einen speziellen Schaltverstärkertyp, den Treppenstufenmodulator oder Pulse-Step-Modulator (PSM) einzusetzen, weil dieser Schaltverstärker den Senderaufbau und insbesondere die Anodenspannungsversorgung der Senderendröhre vereinfacht und andererseits in der Senderanwendung bereits erprobt ist.

Die Erfindung wird nachfolgend anhand der Zeichnung beschrieben und näher erläutert.

Die einzige Figur zeigt das Blockschaltbild eines ESB-Senders nach der Erfindung. Das niederfrequente bzw. Audiosignal, das durch den Sender übertragen werden soll, gelangt über einen NF-Eingang 13 in an sich bekannter Weise auf ein Tiefpassfilter 12, welches die Bandbreite des NF-Signals auf ein vorbestimmtes Mass begrenzt. Hinter das Tiefpassfilter 12 ist ein Einseitenband (ESB)-Generator 15 geschaltet, der zwei gleichartige ESB-Modulatoren 1 und 1′ enthält. Der eine Modulator 1 ist einem FM-Pfad 3 zugeordnet, der andere Modulator 1′ einem AM-Pfad 4. Der Signalweg verzweigt sich bereits hinter dem Tiefpassfilter 12. Der eine Zweig führt direkt zum ESB-Modulator 1′ des AM-Pfades, während der andere Zweig den ESB-Modulator 1 über eine Signalkorrekturschaltung 9 erreicht.

In den beiden ESB-Modulatoren 1 und 1′ wird das bandbreitenbegrenzte NF-signal zusammen mit einer Hilfsfrequenz aus einem Hilfsfrequenzgenerator 16 jeweils zu einem ESB-signal aufbereitet. Dies geschieht beispielsweise nach dem bekannten Verfahren der Amplitudenmodulation mit nachfolgender Unterdrückung eines seitenbandes und der Hilfsfrequenz.

Hinter dem ESB-Generator 15 führt der Signalweg einerseits vom Ausgang des ESB-Modulators 1 über den FM-Pfad 3 und anderseits vom Ausgang des ESB-Modulators 1′ über den AM-Pfad 4 zu einem HF-Verstärker 2, der das ESB-Signal mit hoher Leistung an eine Antenne 14 abgibt. Der FM-Pfad 3, über den die phasenmodulierte Komponente des ESB-Signals zum HF-Verstärker 2 gelangt, enthält im wesentlichen die Kombination aus einer Mischstufe 10 und einem Trägerfrequenzoszillator 11, sowie einen nachgeschalteten Begrenzerverstärker 7. In der Mischstufe 10 wird das ESB-Signal üblicherweise auf die gewünschte Trägerfrequenz des Senders umgesetzt. Das resultierende Signal erscheint am Eingang des Begrenzerverstärkers 7, der die amplitudenmodulierte Komponente weitgehend unterdrückt und die phasenmodulierte Komponente bereits verstärkt an den nachfolgenden HF-Verstärker 2 weiterleitet, wo sie, wie bei der AM-Modulation, als Trägerfrequenz auf ein Steuergitter der Senderöhre gegeben wird.

Der AM-Pfad 4 läuft über einen Hüllkurvendetektor 5, eine Phasenkorrekturschaltung 8 und einen als Schaltverstärker ausgeführten Amplitudenmodulator 6 zum HF-Verstärker 2. Der Schaltverstärker ist vorteilhafterweise ein Treppenstufenmodulator (PSM), wie er aus der Druckschrift BBC Mitteilungen, 1982, S.212 ff. bekannt ist. Ein solcher Schaltverstärker, der ein analoges Eingangssignal durch ein gesteuertes Zu- und Abschalten diskreter Schaltstufen in Form eines Treppenzuges nachbildet, gewährleistet in besonders günstiger Art aufgrund seines Arbeitsprinzips die notwendige Gleichspannungskopplung zwischen dem Hüllkurvendetektor 5 und dem HF-Verstärker 2. Auf diese Weise werden die Gleichspannungsanteile, die in der Hüllkurve bzw. der amplitudenmodulierten Komponente des ESB-Signals am Ausgang des Hüllkurvendetektors 5 enthalten sind, auf den HF-Verstärker 2 übertragen und bewirken dort die notwendige Trägersteuerung des Senders.

Wegen des besonderen Charakters des ESB-Signals ist die Hüllkurve bei einem sinusförmigen NF-Eingangssignal nicht länger sinusförmig, sondern enthält, je nach Modulationsgrad, mehr oder weniger stark ausgeprägte Oberwellen, die bei der gewählten Uebertragungscharakteristik des AM-Pfades 4 berücksichtigt werden müssen. Da dem Schaltverstärker intern am Ausgang zur Unterdrückung der Schaltfrequenz notwendigerweise ein in der Figur nicht eingezeichnetes Tiefpassfilter nachgeschaltet ist, das Phasenverschiebungen zwischen einer Grundwelle und den ihr zugehörigen Oberwellen hervorruft, werden erfindungsgemäss die Frequenzen in der Phasenkorrekturschaltung 8 phasenmässig so vorverzerrt, dass sich die Verzerrungen aus beiden Schaltungsteilen in der Addition gerade aufheben. Insgesamt ergibt sich daraus für den AM-Pfad 4 ein lückenloser und phasenrichtiger Frequenzgang, der von 0 Hz bis zu einer Grenzfrequenz $f_{Max}$ reicht.

Die Signalkorrekturschaltung 9 erfüllt verschiedene Aufgaben: Der AM-Pfad 4 und der FM-Pfad 3 haben wegen der in ihnen angeordneten, unterschiedlichen Schaltungsteile ein entsprechend unterschiedliches Uebertragungsverhalten. Insbesondere wird dieses Verhalten beim AM-Pfad 4 wesentlich durch die Uebertragungscharakteristik des Amplitudenmodulators 6, speziell in der Form eines Schaltverstärkers, mitbestimmt. Um das ESB-Signal im HF-Verstärker 2 aus der phasenmodulierten und der amplitudenmodulierten Komponente möglichst unverfälscht wiedergewinnen zu können, ist es wichtig, das Uebertragungsverhalten beider Pfade weitgehend anzugleichen. Daher bildet die Signalkorrekturschaltung 9 die Uebertragungscharakteristik des Amplitudenmodulators 6 nach. Dies führt auf der einen Seite zu einer Korrektur des Frequenzganges und auf der anderen Seite können Verzögerungszeiten, die bei der Digital-Analog-Wandlung in einem Schaltverstärker entstehen, ausgeglichen werden. Erfindungsgemäss wird die Signalkorrekturschaltung 9 im FM-Pfad 3 vor dem zugehörigen ESB-Modulator 1 angeordnet, weil dort die Korrektur im Niederfrequenzbereich stattfinden kann, während das ESB-Signal am Ausgang des Modulators 1 bereits zu wesentlich höheren Frequenzen hin verschoben ist und eine Korrektur an dieser Stelle vergleichsweise komplizierter und in der Realisierung aufwendiger ist.

Weiterhin ist es für die Qualität der Rundfunkübertragungen von Vorteil, den AM-Pfad 4 in seinen Uebertragungseigenschaften so auszulegen, dass er innerhalb einer Bandbreite von 0 Hz bis wenigstens 5 kHz weitgehend linear ist, weil so die Verzerrungen auf ein unbedenkliches Mass reduziert werden können.

Insgesamt ergibt sich aus der Erfindung ein ESB-Sender für Rundfunkübertragungen, der bei guter Uebertragungsqualität und reduzierter Bandbreite einen gesamthaft hohen Wirkungsgrad und eine entsprechend hohe Leistungsabgabe aufweist und ohne grossen schaltungstechnischen Mehraufwand realisiert werden kann. Insbesondere lässt sich ein solcher ESB-Sender durch einfache Modifizierung bereits vorhandener AM-Sender verwirklichen, so dass entweder bei gleichbleibender Reichweite die Betriebskosten bestehender Anlagen verringert oder bei gleichbleibendem Leistungseinsatz die Reichweite erheblich erhöht werden können.

**Patentansprüche**

1. Einseitenbandsender mit einem Einseitenband-Generator (15) und einem Hochfrequenzverstärker (2), die über einen Frequenzmodulationspfad (3) und einen Amplitudenmodulationspfad (4) miteinander in Verbindung stehen, wobei der Amplitudenmodulationspfad (4) einen Detektor und einen Amplitudenmodulator (6) und der Frequenzmodulationspfad (3) einen Begrenzerverstärker (7) enthalten, der Amplitudenmodulationspfad (4) vom Ausgang des Detektors bis zum Hochfrequenzverstärker (2) gleichspannungsgekoppelt ist, der Detektor ein Hüllkurvendetektor (5), und der Amplitudenmodulator (6) ein Schaltverstärker ist, dadurch gekennzeichnet, dass im Amplitudenmodulationspfad (4) zwischen dem Hüllkurvendetektor (5) und dem Amplitudenmodulator (6) eine Phasenkorrekturschaltung (8) angeordnet ist, dass der Einseitenband-Generator (15) aus zwei gleichartigen Einseitenband-Modulatoren (1,1′) aufgebaut ist, von denen jeweils ein Einseitenband-Modulator (1,1′) einem Modulationspfad (3,4) zugeordnet ist, und dass vor dem Einseitenband-Modulator (1) des Frequenzmodulationspfades (3) in diesem Pfad eine Signalkorrekturschaltung (9) angeordnet ist, welche die Uebertragungscharakteristik des Amplitudenmodulators (6) nachbildet.

2. Einseitenbandsender nach Anspruch 1, dadurch gekennzeichnet, dass der Amplitudenmodulationspfad (4) eine Bandbreite von 0 Hz bis wenigstens 5 kHz und innerhalb dieser Bandbreite einen linearen Frequenzgang aufweist.

3. Einseitenbandsender nach Anspruch 1, dadurch gekennzeichnet, dass der Amplitudenmodulator (6) ein Treppenstufenmodulator (PSM) ist.

**Claims**

1. Single-sideband transmitter comprising a single-sideband generator (15) and a radio-frequency amplifier (2) which are connected to each other via a frequency modulation path (3) and an amplitude modulation path (4), in which arrangement the amplitude modulation path (4) contains a detector and an amplitude modulator (6) and the frequency modulation path (3) contains a limiter amplifier (7), and the amplitude modulation path (4) is direct-voltage coupled from the output of the detector up to the radio-frequency amplifier (2), the detector is an envelope detector (5) and the amplitude modulator (6) is a switching amplifier, characterized in that a phase correction circuit (8) is arranged in the amplitude modulation path (4) between the envelope detector (5) and the amplitude modulator (6), that the single-sideband generator (15) is constructed of two similar single-sideband modulators (1, 1′) of which in each case one single-sideband modulator (1, 1′) is associated with one modulation path (3, 4), and that a signal correction circuit (9) is arranged in this path in front of the single-sideband modulator (1) of the frequency modulation path (3), which simulates the transmission characteristics of the amplitude modulator (6).

2. Single-sideband transmitter according to Claim 1, characterized in that the amplitude modulation path (4) has a bandwith of 0 Hz to at least 5 kHz and has a linear frequency response within this bandwith.

3. Single-sideband transmitter according to Claim 1, characterized in that the amplitude modulator (6) is a stair-step modulator (PSM).

**Revendications**

1. Emetteur à bande latérale unique comportant un générateur à bande latérale unique (15) et un amplificateur de haute fréquence (2) qui sont connectés l'un à l'autre par l'intermédiaire d'une voie de modulation de fréquence (3) et d'une voie de modulation d'amplitude (4), la voie de modulation d'amplitude (4) comprenant un détecteur et un modulateur d'amplitude (6) et la voie de modulation de fréquence (3) comprenant un amplificateur limiteur (7), et la voie de modulation d'amplitude (4) étant couplée en tension continue de la sortie du détecteur jusqu'à l'amplificateur à haute fréquence (2), le détecteur est un détecteur d'enveloppante (5) et le modulateur d'amplitude (6) est un amplificateur de commutation, caractérisé en ce que dans la voie de modulation d'amplitude (4) entre le détecteur d'enveloppante (5) et le modulateur d'amplitude (6), est disposé un circuit de correction de phase (8), que le générateur à bande latérale unique (15) est constitué de deux modulateurs à bande latérale unique semblables (1, 1′), un modulateur à bande latérale unique (1, 1′) étant chaque fois associé à une voie de modulation (3, 4) et que devant le modulateur à bande latérale unique (1) de la voie de modulation de fréquence (3), est disposé, dans cette voie, un circuit de correction de signal (9) qui copie la caractéristique de transmission du modulateur d'amplitude (6).

2. Emetteur à bande latérale unique suivant la revendication 1, caractérisé en ce que la voie de modulation d'amplitude (4) présente une largeur de bande de 0 Hz jusqu'à au moins 5 kHz et, à l'intérieur de cette largeur de bande, une réponse en fréquence linéaire.

3. Emetteur à bande latérale unique suivant la revendication 1, caractérisé en ce que le modulateur d'amplitude (6) est un modulateur d'impulsions en escalier (PSM).

FIG.